(19) Europäisches Patentamt
European Patent Office
Office européen des brevets

(11) **EP 2 856 653 B1**

(12) **EUROPÄISCHE PATENTSCHRIFT**

(45) Veröffentlichungstag und Bekanntmachung des Hinweises auf die Patenterteilung:
**22.02.2017 Patentblatt 2017/08**

(51) Int Cl.:
*H03M 5/14* *(2006.01)*      *H04L 25/49* *(2006.01)*
*H03K 19/20* *(2006.01)*

(21) Anmeldenummer: **13756811.9**

(22) Anmeldetag: **27.05.2013**

(86) Internationale Anmeldenummer:
**PCT/DE2013/200017**

(87) Internationale Veröffentlichungsnummer:
**WO 2013/174378 (28.11.2013 Gazette 2013/48)**

(54) **VORRICHTUNG UND VERFAHREN FÜR DIE 5B/6B-KODIERUNG**

DEVICE AND METHOD FOR 5B/6B CODING

DISPOSITIF ET PROCÉDÉ DE CODAGE 5B/6B

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.05.2012 DE 102012104573**

(43) Veröffentlichungstag der Anmeldung:
**08.04.2015 Patentblatt 2015/15**

(73) Patentinhaber: **Silicon Line GmbH**
**80687 München (DE)**

(72) Erfinder: **JANSEN, Florian**
**85452 Moosinning, Ortsteil Eichenried (DE)**

(74) Vertreter: **Hofmann, Andreas et al**
**RGTH**
**Patentanwälte PartGmbB**
**Postfach 33 02 11**
**80062 München (DE)**

(56) Entgegenhaltungen:
**EP-A2- 0 294 614      US-A1- 2004 233 075**

- **WIDMER A X ET AL: "A DC-BALANCED, PARTITIONED-BLOCK, 8B/10B TRANSMISSION CODE", IBM JOURNAL OF RESEARCH AND DEVELOPMENT, INTERNATIONAL BUSINESS MACHINES CORPORATION, NEW YORK, NY, US, Bd. 27, Nr. 5, 1. September 1983 (1983-09-01), Seiten 440-451, XP000560679, ISSN: 0018-8646**
- **YONG-WOO KIM ET AL: "An 8B/10B encoder with a modified coding table", PROC. IEEE ASIA PACIFIC CONFERENCE ON CIRCUITS AND SYSTEMS 2008 (APCCAS 2008), IEEE, PISCATAWAY, NJ, USA, 30. November 2008 (2008-11-30), Seiten 1522-1525, XP031405295, DOI: 10.1109/APCCAS.2008.4746322 ISBN: 978-1-4244-2341-5**
- **ALBERT X WIDMER: "8B/10B Encoding and Decoding for High Speed Applications", RC23408 (W0411-032) NOVEMBER 3, 2004 ELECTRICAL ENGINEERING IBM RESEARCH REPORT, 3. November 2004 (2004-11-03), Seiten 1-33, XP055084744, in der Anmeldung erwähnt**
- **SONG YU-YUN ET AL: "A 0.18Â[mu]m pipelined 8B10B encoder for a high-speed SerDes", PROC. 12TH IEEE INTERNATIONAL CONFERENCE ON COMMUNICATION TECHNOLOGY (ICCT) 2010, IEEE, PISCATAWAY, NJ, USA, 11. November 2010 (2010-11-11), Seiten 1039-1042, XP031849834, DOI: 10.1109/ICCT.2010.5688778 ISBN: 978-1-4244-6868-3**

EP 2 856 653 B1

## Beschreibung

### Technisches Gebiet

Die vorliegende Erfindung betrifft grundsätzlich das technische Gebiet optischer und/oder elektrischer, insbesondere serialisierter, Signalverbindungen; im Spezielleren betrifft die vorliegende Erfindung eine für die fünf Bit / sechs Bit (= 5b/6b)-Kodierung und -Dekodierung bestimmte Kodiervorrichtung sowie *ein* entsprechendes Verfahren.

### Stand der Technik, insbesondere dessen Nachteile und technische Probleme

Um ein D[irect]C[urrent]-balanciertes Signal zu erhalten, werden Kodier- und Dekodierverfahren mit verschiedenen Bitbreiten eingesetzt. Die bekannteste ist die acht Bit / zehn Bit (= 8b/10b)-Kodierung und -Dekodierung. Eine derartige 8b/10b-Kodierung/Dekodierung weist in den meisten Fällen einen 5b/6b-Kodier-/Dekodier-Block und einen 3b/4b-Kodier-/Dekodier-Block auf.

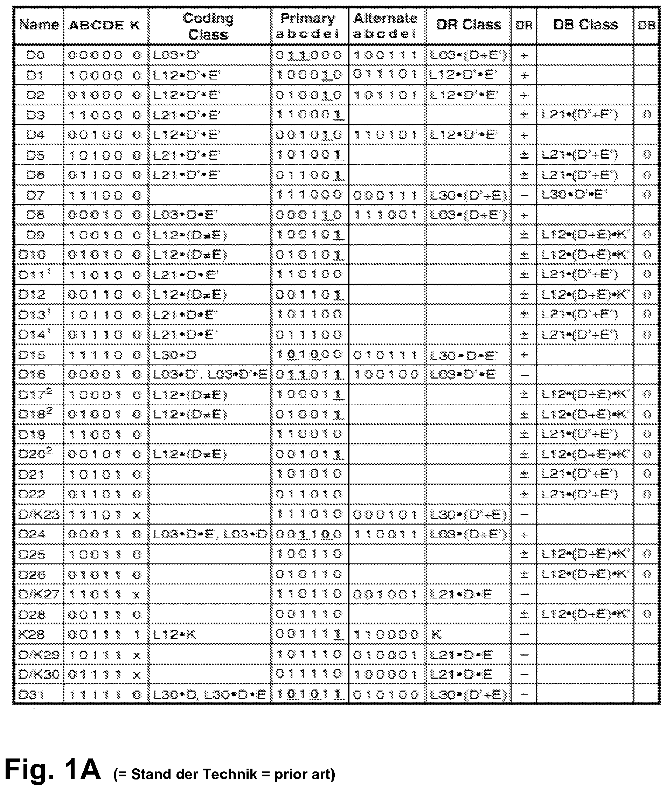

Als Grundlage für derartige 5b/6b-Blöcke und für derartige 3b/4b-Blöcke werden zumeist die Anleitung und die Tabelle von Albert X. Widmer (IBM Research Division) eingesetzt. Zum diesbezüglichen technologischen Hintergrund kann exemplarisch auf die Druckschrift US 6 911 921 B2 oder auf den am 21. Oktober 2004 / 3. November 2004 veröffentlichten Aufsatz "8B/10B Encoding and Decoding for High Speed Applications" von Albert X. Widmer (IBM Research Division) aus dem Stand der Technik aufmerksam gemacht werden. Fig. 1A zeigt diese Widmersche 5b/6b-Kodiertabelle.

Entsprechende Kodiervorrichtungen zur Kodierung von 5b/6b-Kodes sind aus dem Stand der Technik bekannt, so zum Beispiel

- aus dem von Albert X. Widmer und Peter A. Franaszek in IBM Journal of Research and Development, Bd 27, Nr 5, Seiten 440 bis 451, veröffentlichten Aufsatz "A DC-balanced, partitioned-block, 8B/10B transmission code",
- aus dem von Yong-Woo Kim und Jin-Ku Kang in Proc. IEEE Asia Pacific Conference on Circuits and Systems 2008 (APCCAS 2008), Seiten 1522 bis 1525, veröffentlichten Aufsatz "An 8B/10B encoder with a modified coding table" oder
- aus der Druckschrift EP 0 294 614 A2.

Jedoch sind die von Widmer und von anderen genannten Schaltungsanordnungen, in Abhängigkeit von der verwendeten Technologie, nur bis zu gewissen Taktraten nutzbar, denn bei derartigen konventionellen Schaltungsanordnungen addieren sich die Laufzeiten vieler nacheinander geschalteter digitaler Gatter. Dies verhindert einen hohen kodierten Datendurchsatz.

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine für die fünf Bit / sechs Bit (= 5b/6b)-Kodierung und -Dekodierung bestimmte Kodiervorrichtung sowie *ein* entsprechendes Verfahren so weiterzubilden, dass eine hohe Durchsatzrate kodierter Daten erzielbar ist.

Diese Aufgabe wird durch eine Kodiervorrichtung mit den Merkmalen des Anspruchs *1* sowie durch ein Kodierverfahren mit den Merkmalen des Anspruchs *5* gelöst. Vorteilhafte Ausgestaltungen und zweckmäßige Weiterbildungen der vorliegenden Erfindung sind in den jeweiligen Unteransprüchen gekennzeichnet.

Erfindungsgemäß wird mittels einer fünf Bit / sechs Bit-Encoder-Architektur (5b/6b-Encoder-Architektur) eine D[irect]C[urrent]-balancierte optische und/oder elektrische, insbesondere serielle, Datenverbindung bereit gestellt.

Die vorliegende Erfindung betrifft schließlich die Verwendung mindestens einer *Kodiervorrichtung* gemäß der vorstehend dargelegten Art und/oder eines Verfahrens gemäß der vorstehend dargelegten Art beim Kodieren von fünf Bit breiten digitalen Signalen in sechs Bit breite, D[irect]C[urrent]-balancierte oder gleichstromneutral übertragbare Signale, insbesondere in der serialisierten optischen und/oder elektrischen Signalübertragung und/oder -verarbeitung.

### Kurze Beschreibung der Zeichnungen

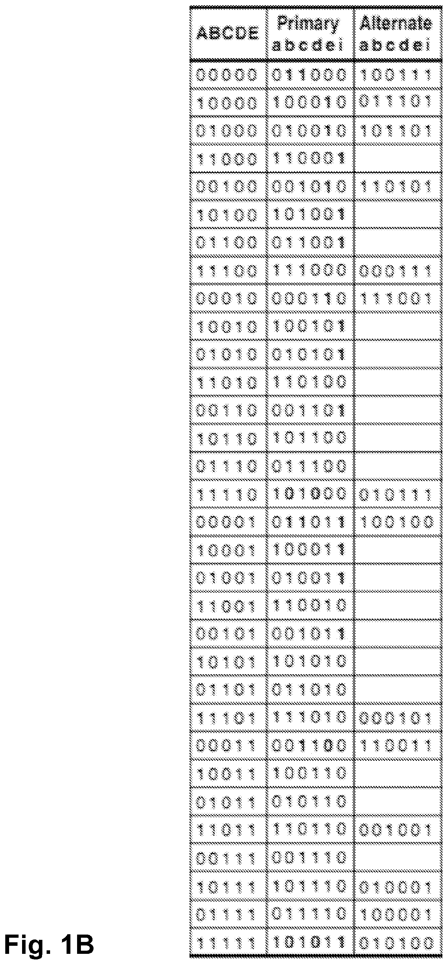

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 sowie dem Anspruch *6* nachgeordneten Ansprüche verwiesen, andererseits werden weitere Ausgestaltungen, Merkmale und Vorteile der vorliegenden Erfindung nachstehend unter Anderem anhand des durch Fig. 1B bis Fig. 3F veranschaulichten Ausführungsbeispiels näher erläutert. Es zeigt:

Fig. 1A  ein Ausführungsbeispiel für eine auf Albert X. Widmer (IBM Research Division) zurückgehende 5b/6b-Kodiertabelle, mittels derer fünf Eingangsbits in sechs Ausgangsbits gewandelt werden können;

Fig. 1B  ein Ausführungsbeispiel für eine auf Albert X. Widmer (IBM Research Division) zurückgehende, jedoch abgewandelte, insbesondere reduzierte, 5b/6b-Kodiertabelle, mittels derer fünf Eingangsbits in sechs Ausgangsbits gewandelt werden können und die bei der vorliegenden Erfindung zum Einsatz gelangen kann;

Fig. 2     in konzeptuell-schematischer Darstellung ein Ausführungsbeispiel für eine Schaltungsanordnung, die nach dem Verfahren gemäß der vorliegenden Erfindung arbeitet;

Fig. 3A     in konzeptuell-schematischer Darstellung ein Ausführungsbeispiel für einen ersten Bestandteil einer fünf Bit / sechs Bit-Kodiervorrichtung (5b/6b-Kodiervorrichtung) gemäß der vorliegenden Erfindung, die nach dem Kodierverfahren gemäß der vorliegenden Erfindung arbeitet;

Fig. 3B     in konzeptuell-schematischer Darstellung ein Ausführungsbeispiel für einen zweiten Bestandteil einer 5b/6b-Kodiervorrichtung gemäß der vorliegenden Erfindung, die nach dem Kodierverfahren gemäß der vorliegenden Erfindung arbeitet;

Fig. 3C     in konzeptuell-schematischer Darstellung ein Ausführungsbeispiel für einen dritten Bestandteil einer 5b/6b-Kodiervorrichtung gemäß der vorliegenden Erfindung, die nach dem Kodierverfahren gemäß der vorliegenden Erfindung arbeitet;

Fig. 3D     in konzeptuell-schematischer Darstellung ein Ausführungsbeispiel für einen vierten Bestandteil einer 5b/6b-Kodiervorrichtung gemäß der vorliegenden Erfindung, die nach dem Kodierverfahren gemäß der vorliegenden Erfindung arbeitet;

Fig. 3E     in konzeptuell-schematischer Darstellung ein Ausführungsbeispiel für einen fünften Bestandteil einer 5b/6b-Kodiervorrichtung gemäß der vorliegenden Erfindung, die nach dem Kodierverfahren gemäß der vorliegenden Erfindung arbeitet; und

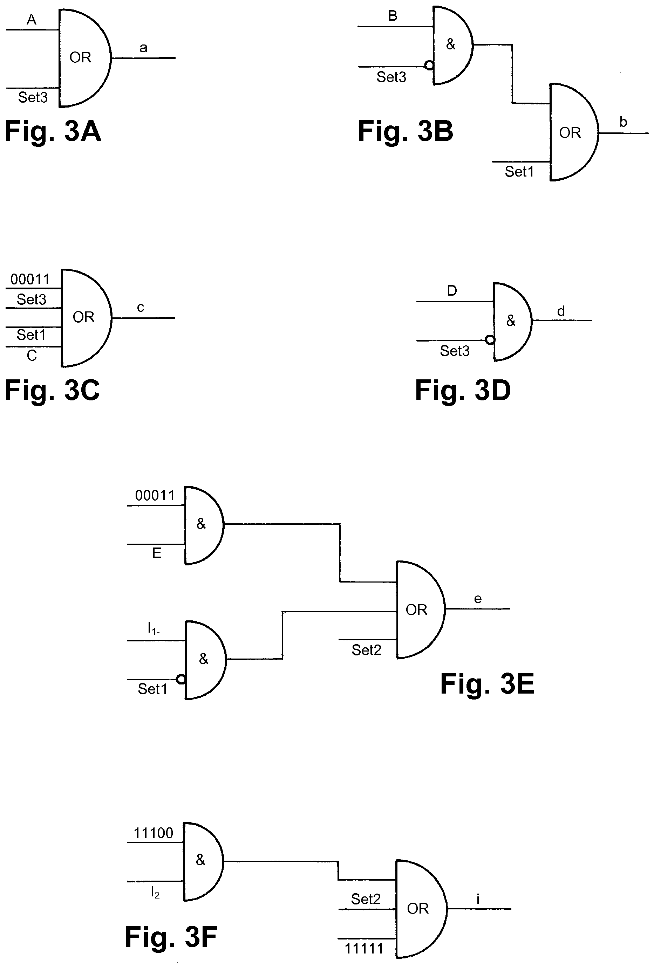

Fig. 3E     in konzeptuell-schematischer Darstellung ein Ausführungsbeispiel für einen sechsten Bestandteil einer 5b/6b-Kodiervorrichtung gemäß der vorliegenden Erfindung, die nach dem Kodierverfahren gemäß der vorliegenden Erfindung arbeitet.

Gleiche oder ähnliche Ausgestaltungen, Elemente oder Merkmale sind in Fig. 1A bis Fig. 3F mit identischen Bezugszeichen versehen.

**Bester Weg zur Ausführung der vorliegenden Erfindung**

Unter Ausnutzung bestimmter Schaltungsanordnungen ist es möglich, einen im Vergleich zur konventionellen Widmerschen 5b/6b-Kodiertabelle gemäß Fig. 1A erhöhten Datendurchsatz für eine fünf Bit / sechs Bit-Kodiervorrichtung (= 5b/6b-Kodierer) gemäß der vorliegenden Erfindung zu erhalten, die gemäß dem fünf Bit / sechs Bit-Kodierverfahren (= 5b/6b-Kodierverfahren) gemäß der vorliegenden Erfindung arbeitet.

Um hierbei kompatibel zu existierenden 5b/6b-Dekodierern zu bleiben, wird für diese 5b/6b-Wandlung die Widmersche 5b/6b-Kodiertabelle gemäß Fig. 1A zwar als Grundlage angesehen, jedoch in abgewandelter, nämlich reduzierter Form gemäß Fig. 1B eingesetzt, wobei Sonderzeichen wie K23 oder K28 aus Fig. 1A nicht berücksichtigt sind.

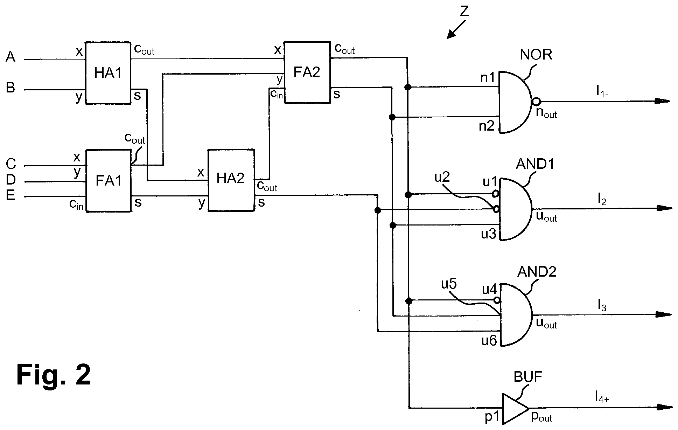

Gemäß dem anhand Fig. 2 veranschaulichten Ausführungsbeispiel wird zunächst eine Schaltungsanordnung Z zur Findung, das heißt zur Bestimmung der Anzahl der Nullen und der Anzahl der Einsen im Eingangswort oder Eingangskodewort eingesetzt, wobei es sich beim Eingangs(kode)wort um ein fünf Bit breites digitales Signal handelt. Die Schaltungsanordnung Z gibt also aus, wie viele Nullen und wie viele Einsen sich im fünf Bit breiten Eingangs(kode)wort befinden, wobei die fünf einzelnen Bits dieser 5 Bit-Eingangs(kode)wörter in Fig. 1B und in Fig. 2 mit den Buchstaben A B C D E bezeichnet sind.

Wie Fig. 2 entnehmbar, weist die Schaltungsanordnung Z unter Anderem auf:

- einen ersten Halbaddierer HA1

    --mit einem ersten Eingangsanschluss x,
    --mit einem zweiten Eingangsanschluss y,
    --mit einem Summenausgangsanschluss s und
    --mit einem Übertragsausgangsanschluss $c_{out}$,

- einen ersten Volladdierer FA1

    --mit einem ersten Eingangsanschluss x,
    --mit einem zweiten Eingangsanschluss y,
    --mit einem Übertragseingangsanschluss $c_{in}$,
    --mit einem Summenausgangsanschluss s und
    --mit einem Übertragsausgangsanschluss $c_{out}$,

- einen zweiten Halbaddierer HA2

    --mit einem ersten Eingangsanschluss x,
    --mit einem zweiten Eingangsanschluss y,
    --mit einem Summenausgangsanschluss s und
    --mit einem Übertragsausgangsanschluss $c_{out}$,

- einen zweiten Volladdierer FA2

    --mit einem ersten Eingangsanschluss x,
    --mit einem zweiten Eingangsanschluss y,
    --mit einem Übertragseingangsanschluss $c_{in}$,
    --mit einem Summenausgangsanschluss s und
    --mit einem Übertragsausgangsanschluss $c_{out}$.

Hierbei handelt es sich bei einem half adder oder Halbaddierer HA1, HA2 um ein Schaltnetz, das üblicherweise als digitale Schaltung realisiert ist. Mit jedem Halbaddierer HA1, HA2 können zwei einstellige Binärzahlen addiert werden, wofür jeder Halbaddierer HA1, HA2 zwei Eingänge x, y aufweist. Jeder Halbaddierer HA1, HA2 weist zwei Ausgänge s, $c_{out}$ auf, nämlich einen Summenausgang s des für das Ergebnis (= digitale Summe) der beiden Eingangssignale und einen Übertragsausgang $c_{out}$ für den Übertrag oder carry des Ergebnisses gemäß folgender Wahrheitstabelle oder truth table, die die Funktionsweise des Halbaddierers HA1, HA2 veranschaulicht:

$$x=0, y=0 \text{ --> } s=0, c_{out}=0$$

$$x=0, y=1 \text{ --> } s=1, c_{out}=0$$

$$x=1, y=0 \text{ --> } s=1, c_{out}=0$$

$$x=1, y=1 \text{ --> } s=0, c_{out}=1$$

Von der mathematischen Funktion her setzt der Halbaddierer HA1, HA2 also den Summenausgang s auf 1, sobald einer der beiden Eingänge x, y eine 1 hat. Der Übertragsausgang $c_{out}$ wird nur dann auf 1 gesetzt, wenn beide Eingänge x, y eine 1 haben.

Bei einem full adder oder Volladdierer FA1, FA2 handelt es sich um ein Schaltnetz, das üblicherweise als digitale Schaltung realisiert ist. Mit jedem Volladdierer FA1, FA2 können drei einstellige Binärzahlen addiert werden, wofür jeder Volladdierer FA1, FA2 drei Eingänge x, y, $c_{in}$ aufweist, wobei einer der drei Eingänge x, y, $c_{in}$ der Übertragseingang $c_{in}$ ist. Jeder Volladdierer FA1, FA2 weist zwei Ausgänge s, $c_{out}$ auf, nämlich einen Summenausgang s für die niederwertige Stelle des Ergebnisses (= der digitalen Summe) der drei Eingangssignale und einen Übertragsausgang $c_{out}$ für die höherwertige Stelle des Ergebnisses, also den Übertrag oder carry des Ergebnisses gemäß folgender Wahrheitstabelle oder truth table, die die Funktionsweise des Volladdierers FA1, FA2 veranschaulicht (das Vorhandensein des Übertragseingangs $c_{in}$ sowie des Übertragsausgangs $c_{out}$ erlaubt hierbei eine Überlaufbehandlung in Addiernetzen):

$$x=0, y=0, c_{in}=0 \text{ --> } s=0, c_{out}=0$$

$$x=0, y=0, c_{in}=1 \text{ --> } s=1, c_{out}=0$$

$$x=0, y=1, c_{in}=0 \text{ --> } s=1, c_{out}=0$$

$$x=1, y=0, c_{in}=0 \text{ --> } s=1, c_{out}=0$$

$$x=0, y=1, c_{in}=1 \text{ --> } s=0, c_{out}=1$$

$$x=1, y=0, c_{in}=1 \text{ --> } s=0, c_{out}=1$$

$$x=1, y=1, c_{in}=0 \text{ --> } s=0, c_{out}=1$$

$$x=1, y=1, c_{in}=1 \text{ --> } s=1, c_{out}=1$$

Von der mathematischen Funktion her setzt der Volladdierer FA1, FA2 also den Summenausgang s auf 1, sobald einer der drei Eingänge x, y, $c_{in}$ eine 1 hat. Haben zwei der drei Eingänge x, y, $c_{in}$ eine 1, dann wird der Übertragsausgang $c_{out}$ auf 1 gesetzt. Haben alle drei Eingänge x, y, $c_{in}$ eine 1, werden beide Ausgänge s und $c_{out}$, also sowohl der Summenausgang s als auch der Übertragsausgang $c_{out}$ auf 1 gesetzt.

Gemäß Fig. 2 wird der erste Eingang x des ersten Halbaddierers HA1 mit dem ersten Bit A des 5 Bit-Eingangs(kode)worts A B C D E beaufschlagt. Der zweite Eingang y des ersten Halbaddierers HA1 wird mit dem zweiten Bit B des 5 Bit-Eingangs(kode)worts A B C D E beaufschlagt.

Da der Übertragsausgang $c_{out}$ des ersten Halbaddierers HA1 mit dem ersten Eingang x des zweiten Volladdierers FA2 verbunden ist, wird der erste Eingang x des zweiten Volladdierers FA2 mit dem Übertragsausgangssignal des ersten Halbaddierers HA1 beaufschlagt.

Da der Summenausgang s des ersten Halbaddierers HA1 mit dem ersten Eingang x des zweiten Halbaddierers HA2 verbunden ist, wird der erste Eingang x des zweiten Halbaddierers HA2 mit dem Summenausgangssignal des ersten Halbaddierers HA1 beaufschlagt.

Der erste Eingang x des ersten Volladdierers FA1 wird mit dem dritten Bit C des 5 Bit-Eingangs(kode)worts A B C D E beaufschlagt. Der zweite Eingang y des ersten Volladdierers FA1 wird mit dem vierten Bit D des 5 Bit-Eingangs(kode)worts A B C D E beaufschlagt. Der Übertragseingang $c_{in}$ des ersten Volladdierers FA1 wird mit dem fünften (= letzten) Bit E des 5 Bit-Eingangs(kode)worts A B C D E beaufschlagt.

Da der Übertragsausgang $c_{out}$ des ersten Volladdierers FA1 mit dem zweiten Eingang y des zweiten Volladdierers FA2 verbunden ist, wird der zweite Eingang y des zweiten Volladdierers FA2 mit dem Übertragsausgangssignal des ersten Volladdierers FA1 beaufschlagt.

Da der Summenausgang s des ersten Volladdierers FA1 mit dem zweiten Eingang y des zweiten Halbaddierers HA2 verbunden ist, wird der zweite Eingang y des zweiten Halbaddierers HA2 mit dem Summenausgangssignal des ersten Volladdierers FA1 beaufschlagt.

Da der Übertragsausgang $c_{out}$ des zweiten Halbaddierers HA2 mit dem Übertragseingang $c_{in}$ des zweiten Volladdierers FA2 verbunden ist, wird der Übertragseingang $c_{in}$ des zweiten Volladdierers FA2 mit dem Übertragsausgangssignal des zweiten Halbaddierers HA2 beaufschlagt.

Wie Fig. 2 des Weiteren entnehmbar, weist die Schaltungsanordnung Z unter Anderem auf:

- ein den beiden Halbaddierern HA1, HA2 sowie den beiden Volladdierern FA1, FA2 nachgeschaltetes N[icht-]O[de]R-Gatter oder N[icht-]O[de]R-Glied NOR

    --mit einem ersten Eingangsanschluss n1,
    --mit einem zweiten Eingangsanschluss n2 und
    --mit einem Ausgangsanschluss $n_{out}$,

- ein den beiden Halbaddierern HA1, HA2 sowie den beiden Volladdierern FA1, FA2 nachgeschaltetes erstes UND-Gatter oder UND-Glied AND1

    --mit einem invertierten oder negierten ersten Eingangsanschluss u1,
    --mit einem invertierten oder negierten zweiten Eingangsanschluss u2,
    --mit einem dritten Eingangsanschluss u3 und
    --mit einem Ausgangsanschluss $u_{out}$,

- ein den beiden Halbaddierern HA1, HA2 sowie den beiden Volladdierern FA1, FA2 nachgeschaltetes zweites UND-Gatter oder UND-Glied AND2

    --mit einem invertierten oder negierten ersten Eingangsanschluss u4,
    --mit einem zweiten Eingangsanschluss u5,
    --mit einem dritten Eingangsanschluss u6 und
    --mit einem Ausgangsanschluss $u_{out}$ sowie

- ein den beiden Halbaddierern HA1, HA2 sowie den beiden Volladdierern FA1, FA2 nachgeschaltetes, zum Beispiel zum Laufzeitausgleich vorgesehenes Pufferglied BUF

    --mit einem Eingangsanschluss $p_{in}$ und
    --mit einem Ausgangsanschluss $p_{out}$.

Dieses NOR-Gatter oder NOR-Glied (= definitionsgemäß ein OR-Gatter oder OR-Glied mit invertiertem oder negiertem Ausgang), diese beiden UND-Gatter oder UND-Glieder AND1, AND2 sowie dieses Pufferglied BUF sind den beiden Halbaddierern HA1 und HA2 sowie den beiden Volladdierern FA1 und FA2 wie folgt nachgeschaltet:

    Da der Übertragsausgang $c_{out}$ des zweiten Volladdierers FA2 mit dem ersten Eingang n1 des NOR-Glieds verbunden ist, wird der erste Eingang n1 des NOR-Glieds mit dem Übertragsausgangssignal des zweiten Volladdierers FA2 beaufschlagt. Da der Summenausgang s des zweiten Volladdierers FA2 mit dem zweiten Eingang n2 des NOR-Glieds verbunden ist, wird der zweite Eingang n2 des NOR-Glieds mit dem Summensignal des zweiten Volladdierers FA2 beaufschlagt. Der Ausgang $n_{out}$ des NOR-Glieds liefert die Information $I_{1-}$, dass sich im fünf Bit breiten Eingangs(kode)wort A B C D E eine Eins (= 1) oder weniger als eine Eins (= 1) befindet, mit anderen Worten also höchstens eine Eins (= 1).

Da der Übertragsausgang $c_{out}$ des zweiten Volladdierers FA2 mit dem invertierten oder negierten ersten Eingang u1 des ersten UND-Glieds AND1 verbunden ist, wird der invertierte oder negierte erste Eingang u1 des ersten UND-Glieds AND1 mit dem Übertragsausgangssignal des zweiten Volladdierers FA2 beaufschlagt. Da der Summenausgang s des zweiten Halbaddierers HA2 mit dem invertierten oder negierten zweiten Eingang u2 des ersten UND-Glieds AND1 verbunden ist, wird der invertierte oder negierte zweite Eingang u2 des ersten UND-Glieds AND1 mit dem Summensignal des zweiten Halbaddierers HA2 beaufschlagt. Da der Summenausgang s des zweiten Volladdierers FA2 mit dem dritten Eingang u3 des ersten UND-Glieds AND1 verbunden ist, wird der dritte Eingang u3 des ersten UND-Glieds AND1 mit dem Summensignal des zweiten Volladdierers FA2 beaufschlagt. Der Ausgang $u_{out}$ des ersten UND-Glieds AND1 liefert die Information $I_2$, dass sich im fünf Bit breiten Eingangs(kode)wort A B C D E zwei Einsen (= 1) befinden.

Da der Übertragsausgang $c_{out}$ des zweiten Volladdierers FA2 mit dem invertierten oder negierten ersten Eingang u4 des zweiten UND-Glieds AND2 verbunden ist, wird der invertierte oder negierte erste Eingang u4 des zweiten UND-Glieds AND2 mit dem Übertragsausgangssignal des zweiten Volladdierers FA2 beaufschlagt. Da der Summenausgang s des zweiten Volladdierers FA2 mit dem zweiten Eingang u5 des zweiten UND-Glieds AND2 verbunden ist, wird der zweite Eingang u5 des zweiten UND-Glieds AND2 mit dem Summensignal des zweiten Volladdierers FA2 beaufschlagt. Da der Summenausgang s des zweiten Halbaddierers HA2 mit dem dritten Eingang u6 des zweiten UND-Glieds AND2 verbunden ist, wird der dritte Eingang u6 des zweiten UND-Glieds AND2 mit dem Summensignal des zweiten Halbaddierers HA2 beaufschlagt. Der Ausgang $u_{out}$ des zweiten UND-Glieds AND2 liefert die Information $I_3$, dass sich im fünf Bit breiten Eingangs(kode)wort A B C D E drei Einsen (= 1) befinden.

Da der Übertragsausgang $c_{out}$ des zweiten Voll-

addierers FA2 mit dem Eingang $p_{in}$ des Pufferglieds BUF verbunden ist, wird der Eingang $p_{in}$ des Pufferglieds BUF mit dem Übertragsausgangssignal des zweiten Volladdierers FA2 beaufschlagt. Der Ausgang $p_{out}$ des Pufferglieds BUF liefert die Information $I_{4+}$, dass sich im fünf Bit breiten Eingangs(kode)wort A B C D E vier Einsen (= 1) oder mehr als vier Einsen (= 1) befinden, mit anderen Worten also mindestens vier Einsen (= 1).

Mittels des Kodieralgorithmus für die 5b/6b-Kodiervorrichtung gemäß der vorliegenden Erfindung werden die 32 zu übertragenden 5 Bit-Eingangs(kode)wörter A B C D E in 6 Bit-Ausgangswörter a b c d e i gewandelt, wobei in Fig. 1B die sechs einzelnen Bits der 6 Bit-Ausgangswörter mit den Buchstaben a, b, c, d, e, i bezeichnet sind.

Die 5b/6b-Kodiervorrichtung gemäß der vorliegenden Erfindung und das 5b/6b-Kodierverfahren gemäß der vorliegenden Erfindung greifen hierbei, wie in Form des nachstehenden, anhand Fig. 3A bis Fig. 3F veranschaulichten Kodierschemas veranschaulicht, auf die durch die Schaltungsanordnung Z gemäß der vorliegenden Erfindung zur Verfügung gestellte Information $I_{1-}$, Information $I_2$, Information $I_3$, Information $I_{4+}$ zu, wobei die Schaltungsanordnung Z

- der 5b/6b-Kodiervorrichtung vorgeschaltet sein kann und/oder
- Teil der 5b/6b-Kodiervorrichtung sein kann und/oder
- einheitlich und/oder einstückig mit der 5b/6b-Kodiervorrichtung ausgebildet sein kann.

Das 5b/6b-Kodierverfahren gemäß der vorliegenden Erfindung stellt also eingehende 5 Bit-Wörter A B C D E im Ergebnis über die exemplarische Kodiertabelle gemäß Fig. 1B in Form von ausgehenden primären 6 Bit-Symbolen a b c d e i (= Primary a b c d e i) wie folgt dar:

a = A ODER Set3.
Diese Kodiervorschrift für das erste Bit a des Ausgangssymbols a b c d e i kann mittels der anhand Fig. 3A exemplarisch veranschaulichten logischen Schaltelemente realisiert sein, durch die eine erste Komponente der fünf Bit/sechs Bit-Kodiervorrichtung (5b/6b-Kodiervorrichtung) gemäß der vorliegenden Erfindung gegeben sein kann.
b = Set1 ODER [B UND Set3_negiert].
Diese Kodiervorschrift für das zweite Bit b des Ausgangssymbols a b c d e i kann mittels der anhand Fig. 3B exemplarisch veranschaulichten logischen Schaltelemente realisiert sein, durch die eine zweite Komponente der fünf Bit / sechs Bit-Kodiervorrichtung (5b/6b-Kodiervorrichtung) gemäß der vorliegenden Erfindung gegeben sein kann.
c = C ODER Set1 ODER Set3 ODER [1 WENN ABCDE=00011].
Diese Kodiervorschrift für das dritte Bit c des Ausgangssymbols a b c d e i kann mittels der anhand Fig. 3C exemplarisch veranschaulichten logischen Schaltelemente realisiert sein, durch die eine dritte Komponente der fünf Bit/sechs Bit-Kodiervorrichtung (5b/6b-Kodiervorrichtung) gemäß der vorliegenden Erfindung gegeben sein kann.
d = D UND Set3_negiert.
Diese Kodiervorschrift für das vierte Bit d des Ausgangssymbols a b c d e i kann mittels der anhand Fig. 3D exemplarisch veranschaulichten logischen Schaltelemente realisiert sein, durch die eine vierte Komponente der fünf Bit/sechs Bit-Kodiervorrichtung (5b/6b-Kodiervorrichtung) gemäß der vorliegenden Erfindung gegeben sein kann.
e = Set2 ODER [E UND (1 WENN ABCDE=00011)] ODER [1 WENN ($I_{1-}$ UND Set1_negiert)].
Diese Kodiervorschrift für das fünfte Bit e des Ausgangssymbols a b c d e i kann mittels der anhand Fig. 3E exemplarisch veranschaulichten logischen Schaltelemente realisiert sein, durch die eine fünfte Komponente der fünf Bit/sechs Bit-Kodiervorrichtung (5b/6b-Kodiervorrichtung) gemäß der vorliegenden Erfindung gegeben sein kann.
i = [1 WENN ABCDE=11111] ODER Set2 ODER [1 WENN ($I_2$ UND ABCDE=11100)].
Diese Kodiervorschrift für das sechste (= letzte) Bit i des Ausgangssymbols a b c d e i kann mittels der anhand Fig. 3F exemplarisch veranschaulichten logischen Schaltelemente realisiert sein, durch die eine sechste Komponente der fünf Bit / sechs Bit-Kodiervorrichtung (5b/6b-Kodiervorrichtung) gemäß der vorliegenden Erfindung gegeben sein kann.

Hierbei ist

Set1 = (1 WENN ABCDE=00000) ODER (1 WENN ABCDE=00001),
und demzufolge ist
Set1_negiert = (0 WENN ABCDE=00000) ODER (0 WENN ABCDE=00001);
Set2 = (1 WENN ABCDE=11111) ODER (1 WENN ABCDE=00001);
Set3 = (1 WENN ABCDE=11111) ODER (1 WENN ABCDE=11110),

und demzufolge ist
Set3_negiert = (0 WENN ABCDE=11111) ODER (0 WENN ABCDE=11110),
wobei
Set1_negiert auch als Set1_invertiert bezeichnet werden kann und
Set3_negiert auch als Set3_invertiert bezeichnet werden kann.
Mittels dieses primären Kodieralgorithmus für den 5b/6b-Kodierer gemäß der vorliegenden Erfindung wird von den 32 zu übertragenden 5 Bit-Eingangs(kode)wörtern A B C D E ein Teil in 6 Bit-Ausgangssymbole oder Ausgangswörter a b c d e i gewandelt, die eine identische Anzahl von Nullen und Einsen, nämlich jeweils drei Nullen und drei Einsen enthalten und demzufolge als balanced oder D[irect]C[urrent]-balanced oder D[irect]C[urrent]-neutral bezeichnet werden, also gleichstromneutral übertragbar sind.

So werden exemplarisch gemäß der Kodiertabelle in Fig. 1B neunzehn der 32 zu übertragenden 5 Bit-Eingangs(kode)wörter A B C D E in gleichstromneutral übertragbare 6 Bit-Ausgangssymbole a b c d e i gewandelt.

Der restliche Teil der 32 zu übertragenden 5 Bit-Eingangs(kode)wörter A B C D E wird in 6 Bit-Ausgangssymbole a b c d e i gewandelt, die nicht eine identische Anzahl von Nullen und Einsen enthalten, sondern

- entweder vier Nullen und zwei Einsen
- oder zwei Nullen und vier Einsen

und demzufolge als unbalanced oder D[irect]C[urrent]-unbalanced oder nicht-D[irect]C[urrent]-neutral bezeichnet werden, also für sich allein genommen nicht gleichstromneutral übertragbar wären.

So werden exemplarisch gemäß der Kodiertabelle in Fig. 1B dreizehn der 32 zu übertragenden 5 Bit-Eingangs(kode)wörter A B C D E in nicht gleichstromneutral übertragbare 6 Bit-Ausgangssymbole a b c d e i gewandelt. Für diese dreizehn Eingangssymbole A B C D E gibt es also jeweils zwei mögliche Ausgangssymbole oder Ausgangswörter, nämlich gemäß Fig. 1B Primary a b c d e i und Alternate a b c d e i.

Ob nun

- das erste oder primäre Ausgangssymbol oder -(kode)wort, also Primary a b c d e i, oder
- das zweite oder alternative Ausgangssymbol oder -(kode)wort, also Alternate a b c d e i (= Inverse oder Negierung des gemäß Fig. 1B jeweiligen Primary a b c d e i),

verwendet wird, hängt vom jeweils zuvor gesendeten unbalancierten Ausgangssymbol ab.

Hierbei wird für das zweite oder alternative Ausgangssymbol oder -(kode)wort Alternate a b c d e i die wie folgt gebildete Disparität DISP berücksichtigt:

DISP = [$I_{1-}$ ODER $I_{4+}$ ODER ABCDE=11100 ODER ABCDE=00011] XOR [ABCDE=11100 ODER ABCDE=00001 ODER ABCDE=11101 ODER ABCDE=11011 ODER [(A ODER B) UND CDE=111]].

Hierbei ist die XOR-Anweisung schaltungstechnisch zum Beispiel durch ein [e]X[clusive ]OR-Gatter oder [e]X[clusive ]OR-Glied realisierbar.

In Abhängigkeit vom Ergebnis dieser ermittelten Disparität DISP wird

- entweder das erste oder primäre Ausgangssymbol oder -(kode)wort (= Primary a b c d e i)
- oder das zweite oder alternative Ausgangssymbol oder -(kode)wort (= Alternate a b c d e i) selektiert und verwendet, um die fehlende D[irect]C[urrent]-Balanciertheit oder fehlende Gleichstromneutralität auszugleichen oder zu kompensieren.

Durch den vorstehend beschriebenen Kodieralgorithmus für den 5b/6b-Kodierer gemäß der vorliegenden Erfindung ist es möglich, einen höheren kodierten Datendurchsatz als bei konventionellen Lösungen zu erzielen.

**Bezugszeichenliste**

| | |
|---|---|
| a | erstes Ausgangsbit des Ausgangskodeworts oder Ausgangsworts a b c d e i |
| A | erstes Eingangsbit des Eingangskodeworts oder Eingangsworts A B C D E |
| AND1 | erstes UND-Gatter oder erstes UND-Glied |
| AND2 | zweites UND-Gatter oder zweites UND-Glied |
| b | zweites Ausgangsbit des Ausgangskodeworts oder Ausgangsworts a b c d e i |
| B | zweites Eingangsbit des Eingangskodeworts oder Eingangsworts A B C D E |
| BUF | Pufferglied |
| c | drittes Ausgangsbit des Ausgangskodeworts oder Ausgangsworts a b c d e i |
| C | drittes Eingangsbit des Eingangskodeworts oder Eingangsworts A B C D E |
| $c_{in}$ | dritter Eingangsanschluss oder Übertragseingangsanschluss des Volladdierers FA1, FA2 |
| $c_{out}$ | Übertragsausgangsanschluss des Volladdierers FA1, FA2 oder des Halbaddierers HA1, HA2 |
| d | viertes Ausgangsbit des Ausgangskodeworts oder Ausgangsworts a b c d e i |
| D | viertes Eingangsbit des Eingangskodeworts oder Eingangsworts A B C D E |
| DISP | Disparität |
| e | fünftes Ausgangsbit des Ausgangskodeworts oder Ausgangsworts a b c d e i |
| E | fünftes oder letztes Eingangsbit des Eingangskodeworts oder Eingangsworts A B C D E |
| FA1 | erster Volladdierer |
| FA2 | zweiter Volladdierer |
| HA1 | erster Halbaddierer |
| HA2 | zweiter Halbaddierer |
| i | sechstes oder letztes Ausgangsbit des Ausgangskodeworts oder Ausgangsworts a b c d e i |
| $I_{1-}$ | erste Information, dass sich Eingangskodewort oder Eingangswort A B C D E eine Eins oder keine Eins befindet |
| $I_2$ | zweite Information, dass sich Eingangskodewort oder Eingangswort A B C D E zwei Einsen befinden |
| $I_3$ | dritte Information, dass sich Eingangskodewort oder Eingangswort A B C D E drei Einsen be- |

finden

$I_{4+}$ vierte Information, dass sich Eingangskodewort oder Eingangswort A B C D E vier Einsen oder fünf Einsen befinden

NOR N[icht-]O[de]R-Gatter oder N[icht-]O[de]R-Glied

$n_{out}$ Ausgangsanschluss des N[icht-]O[de]R-Gatters oder N[icht-]O[de]R-Glieds NOR

n1 erster Eingangsanschluss des N[icht-]O[de]R-Gatters oder N[icht-]O[de]R-Glieds NOR

n2 zweiter Eingangsanschluss des N[icht-]O[de]R-Gatters oder N[icht-]O[de]R-Glieds NOR

$p_{in}$ Eingangsanschluss des Pufferglieds BUF

$p_{out}$ Ausgangsanschluss des Pufferglieds BUF

s Summenausgangsanschluss des Volladdierers FA1, FA2 oder des Halbaddierers HA1, HA2

u1 invertierter oder negierter erster Eingangsanschluss des ersten UND-Gatters oder UND-Glieds AND1

u2 invertierter oder negierter zweiter Eingangsanschluss des ersten UND-Gatters oder UND-Glieds AND1

u3 dritter Eingangsanschluss des ersten UND-Gatters oder UND-Glieds AND1

u4 invertierter oder negierter erster Eingangsanschluss des zweiten UND-Gatters oder UND-Glieds AND2

u5 zweiter Eingangsanschluss des zweiten UND-Gatters oder UND-Glieds AND2

u6 dritter Eingangsanschluss des zweiten UND-Gatters oder UND-Glieds AND2

$u_{out}$ Ausgangsanschluss des ersten UND-Gatters oder UND-Glieds AND1 oder des zweiten UND-Gatters oder UND-Glieds AND2

x erster Eingangsanschluss des Volladdierers FA1, FA2 oder des Halbaddierers HA1, HA2

y zweiter Eingangsanschluss des Volladdierers FA1, FA2 oder des Halbaddierers HA1, HA2

Z Schaltungsanordnung

**Patentansprüche**

**1.** Kodiervorrichtung zum Kodieren eines Eingangsworts A B C D E in ein ein erstes Ausgangsbit a, ein zweites Ausgangsbit b, ein drittes Ausgangsbit c, ein viertes Ausgangsbit d, ein fünftes Ausgangsbit e und ein sechstes Ausgangsbit i aufweisendes digitales Ausgangswort a b c d e i auf Grundlage einer durch mindestens eine Schaltungsanordnung (Z) bestimmten und bereitgestellten

- ersten Information $I_{1-}$, dass in dem ein erstes Eingangsbit A, ein zweites Eingangsbit B, ein drittes Eingangsbit C, ein viertes Eingangsbit D und ein fünftes Eingangsbit E aufweisenden digitalen Eingangswort A B C D E höchstens eines der fünf Eingangsbits A, B, C, D, E den Wert 1 "high" aufweist, und

- zweiten Information $I_2$, dass in dem Eingangswort A B C D E genau zwei der fünf Eingangsbits A, B, C, D, E den Wert 1 "high" aufweisen,

gemäß folgender Kodierungszuordnung für die sechs Ausgangsbits a, b, c, d, e, i:

a = A ODER Set3;
b = Set1 ODER [B UND Set3_negiert];
c = C ODER Set1 ODER Set3 ODER [1 WENN ABCDE=00011];
d = D UND Set3_negiert;
e = Set2 ODER [E UND (1 WENN ABCDE=00011)] ODER [1 WENN ($I_{1-}$ UND Set1_negiert)];
i = [1 WENN ABCDE=11111] ODER Set2 ODER [1 WENN ($I_2$ UND ABCDE=11100)],

wobei Set1 = (1 WENN ABCDE=00000) ODER (1 WENN ABCDE=00001);
Set1_negiert = (0 WENN ABCDE=00000) ODER (0 WENN ABCDE=00001);
Set2 = (1 WENN ABCDE=11111) ODER (1 WENN ABCDE=00001);
Set3 = (1 WENN ABCDE=11111) ODER (1 WENN ABCDE=11110);
Set3_negiert = (0 WENN ABCDE=11111) ODER (0 WENN ABCDE=11110),

und wobei die Schaltungsanordnung (Z) aufweist:

- einen ersten Halbaddierer (HA1)

-- mit einem mit dem ersten Eingangsbit A des Eingangsworts A B C D E beaufschlagten ersten Eingangsanschluss (x),
-- mit einem mit dem zweiten Eingangsbit B des Eingangsworts A B C D E beaufschlagten zweiten Eingangsanschluss (y),
-- mit einem Summenausgangsanschluss (s) und
-- mit einem Übertragsausgangsanschluss ($c_{out}$),

- einen ersten Volladdierer (FA1)

-- mit einem mit dem dritten Eingangsbit C des Eingangsworts A B C D E beaufschlagten ersten Eingangsanschluss (x),
-- mit einem mit dem vierten Eingangsbit D des Eingangsworts A B C D E beaufschlagten zweiten Eingangsanschluss (y),
-- mit einem mit dem fünften Eingangsbit E des Eingangsworts A B C D E beaufschlagten Übertragseingangsanschluss ($c_{in}$),

-- mit einem Summenausgangsanschluss (s) und

-- mit einem Übertragsausgangsanschluss ($c_{out}$),

- einen zweiten Halbaddierer (HA2)

-- mit einem mit dem Summenausgangsanschluss (s) des ersten Halbaddierers (HA1) verbundenen ersten Eingangsanschluss (x),

-- mit einem mit dem Summenausgangsanschluss (s) des ersten Volladdierers (FA1) verbundenen zweiten Eingangsanschluss (y),

- mit einem Summenausgangsanschluss (s) und

-- mit einem Übertragsausgangsanschluss ($c_{out}$),

- einen zweiten Volladdierer (FA2)

-- mit einem mit dem Übertragsausgangsanschluss ($c_{out}$) des ersten Halbaddierers (HA1) verbundenen ersten Eingangsanschluss (x),

-- mit einem mit dem Übertragsausgangsanschluss ($c_{out}$) des ersten Volladdierers (FA1) verbundenen zweiten Eingangsanschluss (y),

-- mit einem mit dem Übertragsausgangsanschluss ($c_{out}$) des zweiten Halbaddierers (HA2) verbundenen Übertragseingangsanschluss ($c_{in}$),

-- mit einem Summenausgangsanschluss (s) und

-- mit einem Übertragsausgangsanschluss ($c_{out}$),

- ein den beiden Halbaddierern (HA1, HA2) sowie den beiden Volladdierern (FA1, FA2) nachgeschaltetes N[icht-]O[de]R-Gatter (NOR)

-- mit einem mit dem Übertragsausgangsanschluss ($c_{out}$) des zweiten Volladdierers (FA2) verbundenen ersten Eingangsanschluss (n1),

-- mit einem mit dem Summenausgangsanschluss (s) des zweiten Volladdierers (FA2) verbundenen zweiten Eingangsanschluss (n2) und

-- mit einem die erste Information $I_{1-}$ bereitstellenden Ausgangsanschluss ($n_{out}$),

- ein den beiden Halbaddierern (HA1, HA2) sowie den beiden Volladdierern (FA1, FA2) nachgeschaltetes erstes UND-Gatter (AND1)

-- mit einem mit dem Übertragsausgangsanschluss ($c_{out}$) des zweiten Volladdierers (FA2) verbundenen invertierten oder negierten ersten Eingangsanschluss (u1),

-- mit einem mit dem Summenausgangsanschluss (s) des zweiten Halbaddierers (HA2) verbundenen invertierten oder negierten zweiten Eingangsanschluss (u2),

-- mit einem mit dem Summenausgangsanschluss (s) des zweiten Volladdierers (FA2) verbundenen dritten Eingangsanschluss (u3) und

-- mit einem die zweite Information $I_2$ bereitstellenden Ausgangsanschluss ($u_{out}$),

- ein den beiden Halbaddierern (HA1, HA2) sowie den beiden Volladdierern (FA1, FA2) nachgeschaltetes zweites UND-Gatter (AND2)

-- mit einem mit dem Übertragsausgangsanschluss ($c_{out}$) des zweiten Volladdierers (FA2) verbundenen invertierten oder negierten ersten Eingangsanschluss (u4),

-- mit einem mit dem Summenausgangsanschluss (s) des zweiten Volladdierers (FA2) verbundenen zweiten Eingangsanschluss (u5),

-- mit einem mit dem Summenausgangsanschluss (s) des zweiten Halbaddierers (HA2) verbundenen dritten Eingangsanschluss (u6) und

-- mit einem eine dritte Information $I_3$, dass in dem Eingangswort A B C D E genau drei der fünf Eingangsbits A, B, C, D, E den Wert 1 "high" aufweisen, bereitstellenden Ausgangsanschluss ($u_{out}$) sowie

- ein den beiden Halbaddierern (HA1, HA2) sowie den beiden Volladdierern (FA1, FA2) nachgeschaltetes Pufferglied (BUF)

-- mit einem mit dem Übertragsausgangsanschluss ($c_{out}$) des zweiten Volladdierers (FA2) verbundenen Eingangsanschluss ($p_{in}$) und

-- mit einem eine vierte Information $I_{4+}$, dass in dem Eingangswort A B C D E mindestens vier der fünf Eingangsbits A, B, C, D, E den Wert 1 "high" aufweisen, bereitstellenden Ausgangsanschluss ($p_{out}$).

2. Kodiervorrichtung gemäß Anspruch 1, **dadurch gekennzeichnet, dass** fehlende D[irect]C[urrent]-Balanciertheit oder fehlende Gleichstromneutralität mittels mindestens einer Disparität DISP berücksichtigbar ist.

3. Kodiervorrichtung gemäß Anspruch 2, **dadurch ge-**

**kennzeichnet, dass** die Disparität DISP gegeben ist durch DISP = [$I_{1-}$ ODER $I_{4+}$ ODER ABCDE=11100 ODER ABCDE=00011] XOR [ABCDE=11100 ODER ABCDE=00001 ODER ABCDE=11101 ODER ABCDE=11011 ODER [(A ODER B) UND CDE=111]].

4. Kodiervorrichtung gemäß mindestens einem der Ansprüche 1 bis 3, **dadurch gekennzeichnet, dass** die Kodiervorrichtung

     - der Schaltungsanordnung (Z) nachgeschaltet ist oder
     - Teil der Schaltungsanordnung (Z) ist und/oder
     - einheitlich und/oder einstückig mit der Schaltungsanordnung (Z) ausgebildet ist.

5. Kodierverfahren zum Kodieren des Eingangsworts A B C D E in das Ausgangswort a b c d e i mittels mindestens einer Kodiervorrichtung gemäß mindestens einem der Ansprüche 1 bis 4.

6. Verwendung mindestens einer Kodiervorrichtung gemäß mindestens einem der Ansprüche 1 bis 4 und/oder eines Verfahrens gemäß Anspruch 5 beim Kodieren von fünf Bit A, B, C, D, E breiten digitalen Signalen in sechs Bit a, b, c, d, e, i breite, D[irect]C[urrent]-balancierte oder gleichstromneutral übertragbare Signale.

7. Verwendung gemäß Anspruch 6 in der serialisierten optischen und/oder elektrischen Signalübertragung und/oder -verarbeitung.

**Claims**

1. A coding device for encoding an input word A B C D E in a digital output word a b c d e i comprising a first output bit a, a second output bit b, a third output bit c, a fourth output bit d, a fifth output bit e and a sixth output bit i on the basis of a

     - first information $I_{1-}$ that in the digital input word A B C D E comprising a first input bit A, a second input bit B, a third input bit C, a fourth input bit D and a fifth input bit E at most only one of the five input bits A, B, C, D, E comprises the value 1 "high", and
     - second information $I_2$ that in the input word A B C D E exactly two of the five input bits A, B, C, D, E comprise the value 1 "high",

determined and provided by at least one circuit arrangement (Z) in accordance with the following coding assignment for the six output bits a, b, c, d, e, i:

     a = A OR Set3;

b = Set1 OR [B AND Set3_negated];
c = C OR Set1 OR Set3 OR [1 IF ABCDE=00011];
d = D AND Set3_negated;
e = Set2 OR [E AND (1 IF ABCDE=00011)] OR [1 IF ($I_{1-}$ AND Set1_negated)];
i = [1 IF ABCDE=11111] OR Set2 OR [1 IF ($I_2$ AND ABCDE=11100)],

     wherein Set1 = (1 IF ABCDE=00000) OR (1 IF ABCDE=00001);
     Set1_negated = (0 IF ABCDE=00000) OR (0 IF ABCDE=00001);
     Set2 = (1 IF ABCDE=11111) OR (1 IF ABCDE=00001);
     Set3 = (1 IF ABCDE=11111) OR (1 IF ABCDE=11110);
     Set3_negated = (0IF ABCDE=11111) OR (0 IF ABCDE=11110),

and said circuit arrangement (Z) comprising:

     - a first half-adder (HA1)

         -- with a first input port (x) provided with the first input bit A of the input word A B C D E,
         -- with a second input port (y) provided with the second input bit B of the input word A B C D E,
         -- with a sum output port (s), and
         -- with a transfer output port ($c_{out}$),

     - a first full-adder (FA1)

         -- with a first input port (x) provided with the third input bit C of the input word A B C D E,
         -- with a second input port (y) provided with the fourth input bit D of the input word A B C D E,
         -- with a transfer input port ($c_{in}$) provided with the fifth input bit E of the input word A B C D E,
         -- with a sum output port (s), and
         -- with a transfer output port ($c_{out}$),

     - a second half-adder (HA2)

         -- with a first input port (x) connected with the sum output port (s) of the first half-adder (HA1),
         -- with a second input port (y) connected with the sum output port (s) of the first full-adder (FA1),
         -- with a sum output port (s), and
         -- with a transfer output port ($c_{out}$),

     - a second full-adder (FA2)

-- with a first input port (x) connected with the transfer output port ($c_{out}$) of the first half-adder (HA1),
-- with a second input port (y) connected with the transfer output port ($c_{out}$) of the first full-adder (FA1),
-- with a transfer input port ($c_{in}$) connected with the transfer output port ($c_{out}$) of the second half-adder (HA2),
-- with a sum output port (s), and
-- with a transfer output port ($c_{out}$),

- a NOR gate (NOR) arranged downstream of the two half-adders (HA1, HA2) as well as of the two full-adders (FA1, FA2)

    -- with a first input port (n1) connected with the transfer output port ($c_{out}$) of the second full-adder (FA2),
    -- with a second input port (n2) connected with the sum output port (s) of the second full-adder (FA2), and
    -- with an output port ($n_{out}$) providing the first information $I_{1-}$,

- a first AND gate (AND1) arranged downstream of the two half-adders (HA1, HA2) as well as of the two full-adders (FA1, FA2)

    -- with an inverted or negated first input port (u1) connected with the transfer output port ($c_{out}$) of the second full-adder (FA2),
    -- with an inverted or negated second input port (u2) connected with the sum output port (s) of the second half-adder (HA2),
    -- with a third input port (u3) connected with the sum output port (s) of the second full-adder (FA2), and
    -- with an output port ($u_{out}$) providing the second information $I_2$,

- a second AND gate (AND2) arranged downstream of the half-adders (HA1, HA2) as well as of the two full-adders (FA1, FA2)

    -- with an inverted or negated first input port (u4) connected with the transfer output port ($c_{out}$) of the second full-adder (FA2),
    -- with a second input port (u5) connected with the sum output port (s) of the second full-adder (FA2),
    -- with a third input port (u6) connected with the sum output port (s) of the second half-adder (HA2), and
    -- with an output port ($u_{out}$) providing the third information $I_3$ that in the input word A B C D E exactly three of the five input bits A, B, C, D, E comprise the value 1 "high", as well as

    - a buffer member (BUF) arranged downstream of the two half-adders (HA1, HA2) as well as of the two full-adders (FA1, FA2)

        -- with an input port ($p_{in}$) connected with the transfer output port ($c_{out}$) of the second full-adder (FA2), and
        -- with an output port ($p_{out}$) providing the fourth information $I_{4+}$ that in the input word A B C D E at least four of the five input bits A, B, C, D, E comprise the value 1 "high".

2. The coding device according to claim 1, **characterized in that** a missing D[irect]C[urrent] balance or a missing direct current neutrality can be taken into account by means of at least one disparity DISP.

3. The coding device according to claim 2, **characterized in that** the disparity DISP is given by DISP = [$I_{1-}$ OR $I_{4+}$ OR ABCDE=11100 OR ABCDE=00011] XOR [ABCDE=11100 OR ABCDE=00001 OR ABCDE=11101 OR ABCDE=11011 OR [(A OR B) AND CDE=111]].

4. The coding device according to at least one of claims 1 to 3, **characterized in that** the coding device

    - is arranged downstream of the circuit arrangement (Z) or
    - is part of the circuit arrangement (Z) and/or
    - is constructed uniformly and/or in one piece with the circuit arrangement (Z).

5. A coding method for encoding the input word A B C D E in the output word a b c d e i by means of at least one coding device according to at least one of claims 1 to 4.

6. Use of at least one circuit device according to at least one of claims 1 to 4 and/or of a method according to claim 5 when encoding five bit A, B, C, D, E wide digital signals in six bit a, b, c, d, e, i wide, D[irect]C[urrent]-balanced or direct-current-neutral transferable signals.

7. The use according to claim 6 in serialised optical and/or electrical signal transfer and/or signal processing.

**Revendications**

1. Dispositif de codage pour coder un mot d'entrée A B C D E dans un mot de sortie a b c d e i numérique comportant un premier bit de sortie a, un deuxième bit de sortie b, un troisième bit de sortie c, un quatrième bit de sortie d, un cinquième bit de sortie e et un sixième bit de sortie i sur la base d'une

- première information $I_{1-}$, définie et affectée par au moins un ensemble circuit (Z), que dans le mot d'entrée A B C D E numérique comportant un premier mot d'entrée A, un deuxième mot d'entrée B, un troisième mot d'entrée C, un quatrième mot d'entrée D et un cinquième mot d'entrée E, au maximum un des cinq bits d'entrée A, B, C, D, E comporte la valeur 1 "haute", et
- deuxième information $I_2$, que dans le mot d'entrée A B C D E exactement deux des cinq bits d'entrée A, B, C, D, E comportent la valeur 1 "haute",

selon l'ordre de codage suivant pour les six bits de sortie a, b, c, d, e, i:

a = A OU Set3;
b = Set1 OU [B ET Set3_négatif];
c = C OU Set1 OU Set3 OU [1 SI ABCDE=00011];
d = D ET Set3_négatif;
e = Set2 OU [E ET (1 SI ABCDE=00011)] OU [1 SI ($I_{1-}$ ET Set1_négatif)];
i = [1 SI ABCDE=11111] OU Set2 OU [1 SI ($I_2$ ET ABCDE=11100)],

Set1 = (1 SI ABCDE=00000) OU (1 SI ABCDE=00001);
Set1_négatif = (0 SI ABCDE=00000) OU (0 SI ABCDE=00001);
Set2 = (1 SI ABCDE=11111) OU (1 SI ABCDE=00001);
Set3 = (1 SI ABCDE=11111) OU (1 SI ABCDE=11110);
Set3_négatif = (0 SI ABCDE=11111) OU (0 SI ABCDE=11110),

et l'ensemble circuit (Z) comportant:

- un premier demi-additionneur (HA1)

-- avec une première connexion d'entrée (x) recevant le premier bit d'entrée A du mot d'entrée A B C D E,
-- avec une deuxième connexion d'entrée (y) recevant le deuxième bit d'entrée B du mot d'entrée A B C D E,
-- avec une connexion de sortie de totalisation (s) et
-- avec une connexion de sortie de transmission ($c_{out}$),

- un premier additionneur complet (FA1)

-- avec une première connexion d'entrée (x) recevant le troisième bit d'entrée C du mot d'entrée A B C D E,
-- avec une deuxième connexion d'entrée (y) recevant le quatrième bit d'entrée D du mot d'entrée A B C D E,
-- avec une connexion d'entrée de transmission ($c_{in}$) recevant le cinquième bit d'entrée E du mot d'entrée A B C D E,
-- avec une connexion de sortie de totalisation (s) et
-- avec une connexion de sortie de transmission ($c_{out}$),

- un deuxième demi-additionneur (HA2)

-- avec une première connexion d'entrée (x) reliée à la connexion de sortie de totalisation (s) du premier demi-additionneur (HA1),
-- avec une deuxième connexion d'entrée (y) reliée à la connexion de sortie de totalisation (s) du premier additionneur complet (FA1),
-- avec une connexion de sortie de totalisation (s) et
-- avec une connexion de sortie de transmission ($c_{out}$),

- un deuxième additionneur complet (FA2)

-- avec une première connexion d'entrée (x) reliée à la connexion de sortie de transmission ($c_{out}$) du premier demi-additionneur (HA1),
-- avec une deuxième connexion d'entrée (y) reliée à la connexion de sortie de transmission ($c_{out}$) du premier additionneur complet (FA1),
-- avec une connexion d'entrée de transmission ($c_{in}$) reliée à la connexion de sortie de transmission ($c_{out}$) du deuxième demi-additionneur (HA2),
-- avec une connexion de sortie de totalisation (s) et
-- avec une connexion de sortie de transmission ($c_{out}$),

- une grille N[on]O[u] (NOU) connectée en aval des deux demi-additionneurs (HA1, HA2) et des deux additionneurs complets (FA1, FA2)

-- avec une première connexion d'entrée (n1) reliée à la connexion de sortie de transmission ($c_{out}$) du deuxième additionneur complet (FA2),
-- avec une deuxième connexion d'entrée (n2) reliée à la connexion de sortie de totalisation (s) du deuxième additionneur complet (FA2) et

-- avec une connexion de sortie ($n_{out}$) fournissant la première information $I_{1-}$,

- une grille ET (ET1) connectée en aval des deux demi-additionneurs (HA1, HA2) et des deux additionneurs complets (FA1, FA2)

    -- avec une première connexion d'entrée inversée ou négative (u1) reliée à la connexion de sortie de transmission ($c_{out}$) du deuxième additionneur complet (FA2),
    -- avec une deuxième connexion d'entrée (u2) inversée ou négative reliée à la connexion de sortie de totalisation (s) du deuxième demi-additionneur (HA2),
    -- avec une troisième connexion d'entrée (u3) reliée à la connexion de sortie de totalisation (s) du deuxième additionneur complet (FA2) et
    -- avec une connexion de sortie ($u_{out}$) fournissant la deuxième information $I_2$,

- une deuxième grille ET (ET2) connectée en aval des deux demi-additionneurs (HA1, HA2) et des deux additionneurs complets (FA1, FA2)

    -- avec une première connexion d'entrée (u4) inversée ou négative reliée à la connexion de sortie de transmission ($c_{out}$) du deuxième additionneur complet (FA2),
    -- avec une deuxième connexion d'entrée (u5) reliée à la connexion de sortie de totalisation (s) du deuxième additionneur complet (FA2),
    -- avec une troisième connexion d'entrée (u6) reliée à la connexion de sortie de totalisation (s) du deuxième demi-additionneur (HA2) et
    -- avec une connexion de sortie ($u_{out}$) fournissant une troisième information $I_3$, que dans le mot d'entrée A B C D E exactement trois des cinq bits d'entrée A, B, C, D, E comportent la valeur 1 "haute", ainsi

- qu'un élément tampon (BUF) monté en aval des deux demi-additionneurs (HA1, HA2) et des deux additionneurs complets (FA1, FA2)

    -- avec une connexion d'entrée ($p_{in}$) reliée à la connexion de sortie de transmission ($c_{out}$) du deuxième additionneur complet (FA2) et
    -- avec une connexion de sortie ($p_{out}$) fournissant une quatrième information $I_{4+}$, que dans le mot d'entrée A B C D E au moins quatre des cinq bits d'entrée A, B, C, D, E comportent la valeur 1 "haute".

2. Dispositif de codage selon la revendication 1, **caractérisé en ce que** la possibilité d'équilibrage en C[ourant]C[ontinu] défectueuse ou neutralité de courant continu défectueuse peut être prise en considération au moyen d'au moins une disparité DISP.

3. Dispositif de codage selon la revendication 2, **caractérisé en ce que** la disparité DISP est donnée par DISP = [$I_{1-}$ OU $I_{4+}$ OU ABCDE=11100 OU ABCDE=00011] XOU [ABCDE=11100 OU ABCDE=00001 OU ABCDE=11101 OU ABCDE=11011 OU [(A OU B) ET CDE=111]].

4. Dispositif de codage selon au moins l'une des revendications 1 à 3, **caractérisé en ce que** le dispositif de codage

    - est monté en aval de l'ensemble circuit (Z) ou
    - est une partie de l'ensemble circuit (Z), et/ou
    - est constitué en une unité et/ou une pièce avec l'ensemble circuit (Z).

5. Procédé de codage pour coder le mot d'entrée A B C D E dans le mot de sortie a b c d e i au moyen d'au moins un dispositif de codage selon au moins l'une des revendications 1 à 4.

6. Utilisation d'au moins un dispositif de codage selon au moins l'une des revendications 1 à 4 et/ou d'un procédé selon la revendication 5 lors du codage de signaux numériques d'une largeur de cinq bits A, B, C, D, E en signaux équilibrés en C[ourant]C[ontinu] ou transmissibles de façon neutre en courant continu, d'une largeur de six bits a, b, c, d, e, i.

7. Utilisation selon la revendication 6 dans la transmission et/ou le traitement optique et/ou électrique sérialisé de signaux.

| Name | ABCDE K | Coding Class | Primary abcdei | Alternate abcdei | DR Class | DR | DB Class | DB |
|---|---|---|---|---|---|---|---|---|
| D0 | 00000 0 | L03•D' | 011000 | 100111 | L03•(D+E') | + | | |
| D1 | 10000 0 | L12•D'•E' | 100010 | 011101 | L12•D'•E' | + | | |
| D2 | 01000 0 | L12•D'•E' | 010010 | 101101 | L12•D'•E' | + | | |
| D3 | 11000 0 | L21•D'•E' | 110001 | | | ± | L21•(D'+E') | 0 |
| D4 | 00100 0 | L12•D'•E' | 001010 | 110101 | L12•D'•E' | + | | |
| D5 | 10100 0 | L21•D'•E' | 101001 | | | ± | L21•(D'+E') | 0 |
| D6 | 01100 0 | L21•D'•E' | 011001 | | | ± | L21•(D'+E') | 0 |
| D7 | 11100 0 | | 111000 | 000111 | L30•(D'+E) | − | L30•D'•E' | 0 |
| D8 | 00010 0 | L03•D•E' | 000110 | 111001 | L03•(D+E') | + | | |
| D9 | 10010 0 | L12•(D≠E) | 100101 | | | ± | L12•(D+E)•K' | 0 |
| D10 | 01010 0 | L12•(D≠E) | 010101 | | | ± | L12•(D+E)•K' | 0 |
| D11[1] | 11010 0 | L21•D•E' | 110100 | | | ± | L21•(D'+E') | 0 |
| D12 | 00110 0 | L12•(D≠E) | 001101 | | | ± | L12•(D+E)•K' | 0 |
| D13[1] | 10110 0 | L21•D•E' | 101100 | | | ± | L21•(D'+E') | 0 |
| D14[1] | 01110 0 | L21•D•E' | 011100 | | | ± | L21•(D'+E') | 0 |
| D15 | 11110 0 | L30•D | 101000 | 010111 | L30•D•E' | + | | |
| D16 | 00001 0 | L03•D', L03•D'•E | 011011 | 100100 | L03•D'•E | − | | |
| D17[2] | 10001 0 | L12•(D≠E) | 100011 | | | ± | L12•(D+E)•K' | 0 |
| D18[2] | 01001 0 | L12•(D≠E) | 010011 | | | ± | L12•(D+E)•K' | 0 |
| D19 | 11001 0 | | 110010 | | | ± | L21•(D'+E') | 0 |
| D20[2] | 00101 0 | L12•(D≠E) | 001011 | | | ± | L12•(D+E)•K' | 0 |
| D21 | 10101 0 | | 101010 | | | ± | L21•(D'+E') | 0 |
| D22 | 01101 0 | | 011010 | | | ± | L21•(D'+E') | 0 |
| D/K23 | 11101 x | | 111010 | 000101 | L30•(D'+E) | − | | |
| D24 | 00011 0 | L03•D•E, L03•D | 001100 | 110011 | L03•(D+E') | + | | |
| D25 | 10011 0 | | 100110 | | | ± | L12•(D+E)•K' | 0 |
| D26 | 01011 0 | | 010110 | | | ± | L12•(D+E)•K' | 0 |
| D/K27 | 11011 x | | 110110 | 001001 | L21•D•E | − | | |
| D28 | 00111 0 | | 001110 | | | ± | L12•(D+E)•K' | 0 |
| K28 | 00111 1 | L12•K | 001111 | 110000 | K | − | | |
| D/K29 | 10111 x | | 101110 | 010001 | L21•D•E | − | | |
| D/K30 | 01111 x | | 011110 | 100001 | L21•D•E | − | | |
| D31 | 11111 0 | L30•D, L30•D•E | 101011 | 010100 | L30•(D'+E) | − | | |

# Fig. 1A (= Stand der Technik = prior art)

| ABCDE | Primary abcdei | Alternate abcdei |
|-------|----------------|------------------|
| 00000 | 011000 | 100111 |
| 10000 | 100010 | 011101 |
| 01000 | 010010 | 101101 |
| 11000 | 110001 |  |
| 00100 | 001010 | 110101 |
| 10100 | 101001 |  |
| 01100 | 011001 |  |
| 11100 | 111000 | 000111 |
| 00010 | 000110 | 111001 |
| 10010 | 100101 |  |
| 01010 | 010101 |  |
| 11010 | 110100 |  |
| 00110 | 001101 |  |
| 10110 | 101100 |  |
| 01110 | 011100 |  |
| 11110 | 101000 | 010111 |
| 00001 | 011011 | 100100 |
| 10001 | 100011 |  |
| 01001 | 010011 |  |
| 11001 | 110010 |  |
| 00101 | 001011 |  |
| 10101 | 101010 |  |
| 01101 | 011010 |  |
| 11101 | 111010 | 000101 |
| 00011 | 001100 | 110011 |
| 10011 | 100110 |  |
| 01011 | 010110 |  |
| 11011 | 110110 | 001001 |
| 00111 | 001110 |  |
| 10111 | 101110 | 010001 |
| 01111 | 011110 | 100001 |
| 11111 | 101011 | 010100 |

Fig. 1B

Fig. 2

Fig. 3A

Fig. 3B

Fig. 3C

Fig. 3D

Fig. 3E

Fig. 3F

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6911921 B2

- EP 0294614 A2

**In der Beschreibung aufgeführte Nicht-Patentliteratur**

- **VON ALBERT X. WIDMER ; PETER A. FRA-NASZEK.** A DC-balanced, partitioned-block, 8B/10B transmission code. *IBM Journal of Research and Development,* vol. 27 (5), 440-451

- **VON YONG-WOO KIM ; JIN-KU KANG.** An 8B/10B encoder with a modified coding table. *Proc. IEEE Asia Pacific Conference on Circuits and Systems 2008,* 2008, 1522-1525